Europäisches Patentamt

European Patent Office

Office européen des brevets

(19)

(11) Veröffentlichungsnummer: **0 219 557**
**B1**

# EUROPÄISCHE PATENTSCHRIFT

(12)

(45) Veröffentlichungstag der Patentschrift:
**10.01.90**

(21) Anmeldenummer: **85112978.3**

(22) Anmeldetag: **12.10.85**

(51) Int. Cl.⁴: **H01J 47/02**

(54) **Verfahren und Vorrichtung zur Überprüfung des Messsignalpfades einer Messeinrichtung.**

(43) Veröffentlichungstag der Anmeldung:
**29.04.87 Patentblatt 87/18**

(45) Bekanntmachung des Hinweises auf die Patenterteilung:
**10.01.90 Patentblatt 90/2**

(84) Benannte Vertragsstaaten:
**CH DE FR GB LI**

(56) Entgegenhaltungen:
**DD-A- 74 119**
**DE-C- 869 425**
**DE-C- 1 101 632**
**US-A- 3 317 823**

(73) Patentinhaber: **LEYBOLD AKTIENGESELLSCHAFT,
Bonner Strasse 498, D-5000 Köln 51(DE)**

(72) Erfinder: **Heinen, Raymond, Dr., Birresborner Strasse 37,
D-5000 Köln 41(DE)**

(74) Vertreter: **Leineweber, Jürgen, Dipl.-Phys.,
Nagelschmiedshütte 8, D-5000 Köln 40(DE)**

ACTORUM AG

## Beschreibung

Die Erfindung bezieht sich auf ein Verfahren zur Überprüfung des Meßsignalpfades eines Massenspektrometers mit einem Ionenfänger, einem dem Ionenfänger vorgelagerten Trenn- oder Ablenksystem und einem diesem nachgeordneten Verstärker zur Bildung eines Spannungs- oder Stromsignals. Außerdem bezieht sich die vorliegende Erfindung auf ein für die Durchführung dieses Verfahrens geeignetes Massenspektrometer.

Massenspektrometer, die einen Ionenfänger und einen sich daran anschließenden Meßverstärker aufweisen, müssen in der Regel hochempfindlich sein. Der Grund dafür liegt darin, daß man bestrebt ist, immer kleinere, auf den Ionenfänger auftreffende Teilchenströme registrieren zu können. Soll z.B. ein Ionenstrom von $10^{-16}$ A, das entspricht einem Strom von ca. 600 Ionen pro Sekunde, gerade noch registriert werden, dann muß der der Erzeugung eines Spannungssignales dienende Widerstand im angeschlossenen Verstärker extrem hochohmig sein. Die dadurch gegebene hohe Empfindlichkeit derartiger Anordnungen bedingt einen vollkommen abgeschirmten Einbau von Ionenfängern und zumindest der ersten Stufe des folgenden Verstärkers. Dadurch ist dieser für das Meßsignal wichtige Teil meist schwer zugänglich.

Will man den Meßsignalpfad in der dem Ionenfänger nachgeordneten Elektronik überprüfen, so muß ein bekannter Strom in den Ionenfänger geleitet werden. Die Einleitung eines Stromes im Bereich von $10^{-12}$ A und weniger stellt jedoch eine Quelle von Fehlern und Ungenauigkeiten nicht nur für den Test-, sondern auch für den Meßbetrieb dar. Empfindlichkeitstests mit Strömen der angegebenen Größenordnung sind deshalb bisher unterblieben, da keines der bisherigen Testverfahren ohne galvanische Verbindung zum Eingang des Meßverstärkers auskam.

Bei einer Ionisationskammer zur Messung von Gammastrahlen, Röntgenstrahlen und harten Betastrahlen mit zwei konzentrischen topfförmigen Elektroden und innerhalb der Innenelektrode eingebauter Elektrometerröhre ist es bekannt (DE-C 1 101 632), das Gitter der Elektrometerröhre fest mit der Innenelektrode zu verbinden. Eine Prüfung der Verstärkerfunktion der Elektrometerröhre erfolgt in der Weise, daß die an der Außenelektrode beim Betrieb der Ionisationskammer anliegende positive Spannung abgeschaltet wird und statt dessen eine linear ansteigende positive Spannung angelegt wird. Diese erzeugt infolge der Kapazität zwischen der Außen- und der Innenelektrode einen konstanten positiven Ladestrom, der die Elektrometerröhre so aussteuert, daß ein konstanter Anodenstrom fließt. Die Größe dieses Stromes ist ein Kriterium für die Funktionsfähigkeit der Elektrometerröhre. Auf ein Massenspektrometer moderner Bauart mit extrem niedrigen Ionenströmen (bis hinunter zu $10^{-16}$ A) ist diese Prüfungsmethode nicht unmittelbar übertragbar.

Der vorliegenden Erfindung liegt die Aufgabe zugrunde, die Überprüfung der einem Ionenfänger eines Massenspektrometers nachgeordneten elektronischen Hilfsmittel selbst bei kleinsten Meßströmen möglich zu machen, ohne dabei die Eigenschaften im Meßbetrieb negativ zu beeinflussen.

Bei einem Verfahren zur Überprüfung des Meßsignalpfades eines Massenspektrometers der eingangs genannten Art wird diese Aufgabe gelöst, indem ein Verschiebestrom in den Ionenfänger eingeleitet wird, der mit Hilfe einer Spannungsänderung an einer Elektrode des Trenn- oder Ablenksystems durch Influenz erzeugt wird. Die in der Nähe des Ionenfängers befindliche Influenzelektrode hat zum Ionenfänger eine feste, meßbare und reproduzierbar konstante Koppelkapazität $C_K$. Unter dieser Voraussetzung läßt sich mit einer bekannten Spannungsänderung an der Influenzelektrode ein bestimmter Verschiebestrom in den Ionenfänger einleiten, ohne eine galvanische Verbindung zum Ionenfänger herzustellen. Damit entfallen auch die damit verbundenen Nachteile, wie Erhöhung der Knotenpunktkapazität und der Leckströme sowie die damit verbundenen Auswirkungen, nämlich Erhöhung des Störsignalpegels und der Drift. Nach diesem Verfahren kann ein Funktionstest, z.B. des unmittelbar angeschlossenen Elektrometerverstärkers in sehr kurzer Zeit und ohne den aufwendigen Eingriff in den Bereich der Hochohmwiderstände durchgeführt werden, da bei einer bekannten Spannungsänderung an der Influenzelektrode ein exakt bestimmbares Signal am Ausgang des Elektrometerverstärkers erzeugt werden kann. Eine Quantifizierung des Meßergebnisses ist ebenfalls möglich.

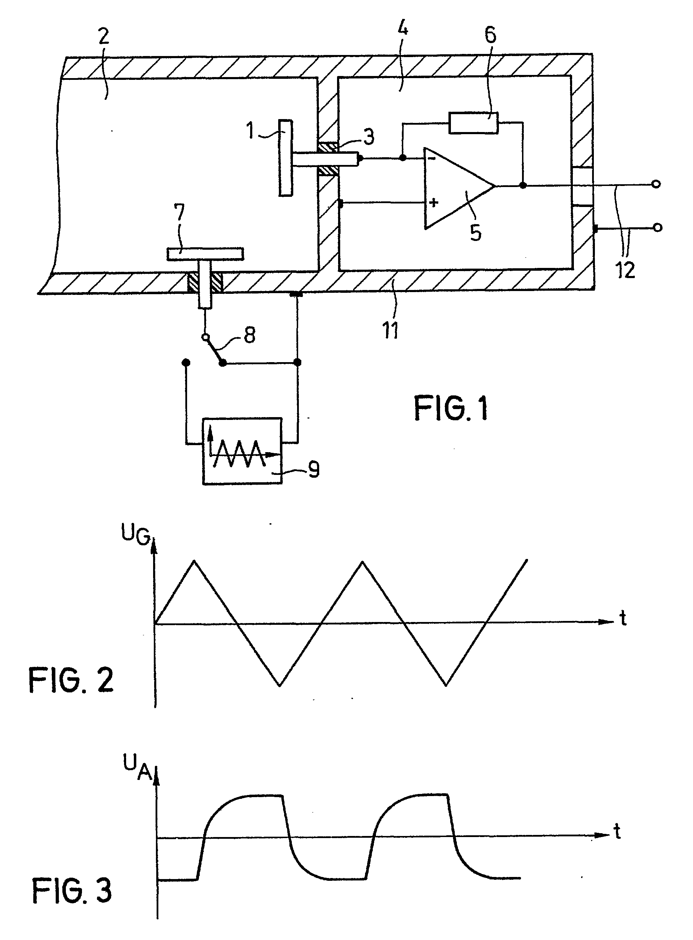

Weitere Vorteile und Einzelheiten der Erfindung sollen anhand von in den Figuren 1 bis 4 dargestellten Ausführungsbeispielen erläutert werden.

Das Ausführungsbeispiel nach Fig. 1 zeigt einen Teilchenfänger 1 in der Vakuumkammer 2. Er ist in ein Massenspektrometer eingebaut und dient dem Auffangen der erzeugten Ionen. Die auf den Teilchenfänger 1 auftreffenden geladenen Teilchen erzeugen einen Strom, der durch den Durchführungs-Isolator 3 in einen Raum 4 geleitet wird. In diesem Raum 4 ist der Verstärker 5 mit seinem Hochohmwiderstand 6 untergebracht, welcher den vom Teilchenfänger 1 gelieferten Strom in ein Spannungssignal umwandelt. Auch die Umwandlung in ein Stromsignal oder in eine dem Teilchenstrom entsprechende Frequenz ist an dieser Stelle häufig gewünscht.

Dem Teilchenfänger 1 ist in geeignetem Abstand innerhalb der Vakuumkammer 2 die Influenzelektrode 7 zugeordnet. Ihre Größe und ihre Anordnung zum Teilchenfänger 1 sind zweckmäßigerweise so gewählt, daß sie eine Kapazität $C_k$ in der Größenordnung Picofarad zum Teilchenfänger 1 hat. Mittels des Schalters 8 kann die Influenzelektrode wahlweise an den Spannungsgenerator 9 angeschlossen (Testzeit) oder geerdet werden (Meßzeit).

Das Gehäuse 11, in dem sich der Raum 4 mit den hochempfindlichen elektronischen Bauteilen 5, 6 befinden, besteht aus Abschirmmaterial, so daß der Verstärker gegen Störungen durch äußere Felder geschützt ist. Auch im Bereich des Teilchenfängers 1 und der Influenzelektrode 7 besteht zweckmäßigerweise eine derartige Abschirmung.

Beim Ausführungsbeispiel nach Fig. 1 ist die Influenzelektrode 7 während des Meßbetriebs geerdet, so daß sie den Meßvorgang nicht beeinträchtigt.

Um sich an den Teilchenfänger 1 anschließenden Meßsignalpfad, insbesondere im Bereich der hochempfindlichen Bauteile, zu testen, wird die Influenzelektrode 7 mit dem Generator 9 verbunden. Dieser erzeugt eine dreiecksförmige Spannung an dieser Elektrode (Fig. 2). Typische Daten dieser Sägezahnspannung liegen im Bereich einer Steigrate von weniger als 1 V/sec und einer Frequenz von 0,1 Hz. Die dreiecksförmige Spannung erzeugt während jeder Phase konstanter Steigung einen konstanten Verschiebestrom im Fänger 1 und somit eine Ausgangsspannung am Ausgang des Verstärkers.

Im Idealfall sieht die Ausgangsspannung rechtecksförmig aus. Real werden die Dachamplituden der rechtecksförmigen Spannung durch Übergangsfunktionen miteinander verbunden. Einen typischen Verlauf der Ausgangsspannung $U_A$ bei vorgegebener Generatorspannung $U_G$ (Fig. 2) zeigt Fig. 3.

Die Scheitelwerte der Ausgangsspannung ergeben sich zu

$$U_A = C_k \cdot \frac{dU_G(t)}{dt}$$

mit $C_k$ als Koppelkapazität zwischen der Influenzelektrode 7 und dem Teilchenfänger 1. Da $C_k$ bekannt und reproduzierbar konstant ist, läßt sich mit einer bekannten Spannung aus dem Generator 9 exakt bestimmbare Signale am Ausgang 12 des Ausführungsbeispiels nach Fig. 1 erzeugen. Bei einem dreiecksförmigen Spannungssignal nach Fig. 2 an der Influenzelektrode 7 ergibt sich am Ausgang 12 eine rechtecksförmige Ausgangsspannung (Fig. 3). Die Differenz der positiven und der negativen Scheitelwerte dieses Ausgangssignals kann als Maß für die Kontrolle der Funktion oder für die Messung der Empfindlichkeit der sich an den Teilchenfänger 1 anschließenden Schaltung verwendet werden.

Dieses Testverfahren ist anwendbar bei allen Verstärkern, die zumindest in ihrer ersten Stufe bipolare Signale, also Wechselspannungssignale, verarbeiten können, da der Mittelwert des Testsignals am Ausgang des Verstärkers stets gleich Null sein muß.

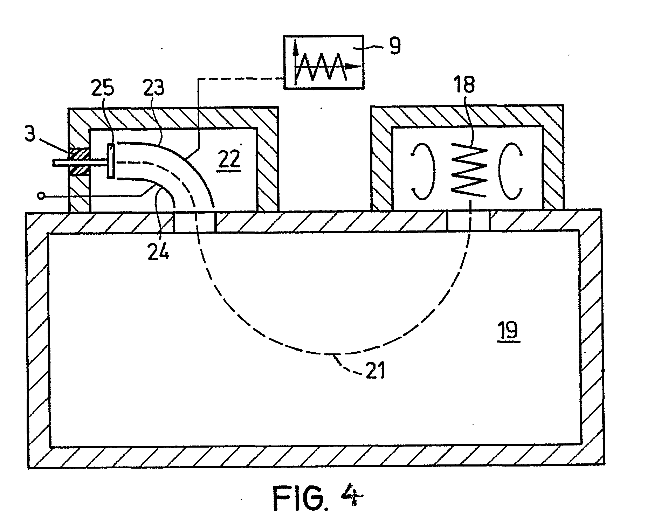

Fig. 4 zeigt ein Massenspektrometer 17, wie es häufig bei Helium-Lecksuchern Anwendung findet. Die Ionenquelle des Massenspektrometers ist mit 18 bezeichnet. Ihr wird in nicht näher dargestellter Weise das zu untersuchende Gas zugeführt. Im Bereich der Kammer 19 befindet sich ein Ablenkfeld für die erzeugten Ionen, das fest auf die Masse des Testgases, z. B. Helium eingestellt ist. Nur die Ionen dieser Masse gelangen auf der gestrichelt eingezeichneten Bahn 21 in den Raum 22, in dem sich die Ablenkelektroden 23, 24 befinden. Mit Hilfe dieser Ablenkelektroden werden die Ionen auf den Ionenfänger 25 geleitet. Der erzeugte Strom wird wieder durch einen Durchführungsisolator 3 einem nicht dargestellten Verstärker 5 zugeführt.

Bei einem Massenspektrometer nach Fig. 4 besteht die Möglichkeit, als Influenzelektrode eine der beiden Ablenkelektroden 23, 24 zu verwenden. Auch dem Teilchenfänger vorgelagerte Elektroden eines Trennsystems (z. B. einer der Pole eines Quadrupolmassenspektrometers) könnte als Influenzelektrode dienen. Während des Testbetriebs wird die betroffene Elektrode mit Generator 9 verbunden und die Kontrolle des Meßsignalpfades in der bereits beschriebenen Weise vorgenommen.

Bei dem in Figur 4 beschriebenen Ausführungsbeispiel besteht die Möglichkeit, die Überprüfung des Meßsignalpfades bei eingeschaltetem Massenspektrometer vorzunehmen. Während des Meßbetriebes liegt an der Elektrode 23, die während des Testbetriebs als Influenzelektrode verwendet wird, eine Gleichspannung an. Dieser Gleichspannung kann die sägezahnförmige Wechselspannung aus dem Generator 9 überlagert werden, so daß der gewünschte Verschiebestrom in den Ionenfänger 25 eingeleitet wird. Voraussetzung für eine zuverlässige Überprüfung der angeschlossenen Elektronik nach dieser Methode ist allerdings, daß in der Zeit des Testbetriebs relativ stabile Druckzustände herrschen.

Eine besonders vorteilhafte Gestaltung des Testbetriebs besteht darin, vor Beginn jeder Messung die an der als Influenzelektrode dienenden Elektrode 23 anzulegende Betriebsspannung rampenförmig hochzufahren und nicht - wie üblich - mit unkontrolliertem Verlauf einzuschalten. An die Influenzelektrode wird also nur eine der vielen Anstiegsflanken gelegt, die sonst vom Generator 9 erzeugt werden. Der infolge dieser einzigen, definierten Anstiegsflanke der anzulegenden Spannung in den Ionenfänger 25 eingeleitete Verschiebestrom kann zur Überprüfung des Signalpfades ohne besonderen Zusatzaufwand und zu einem Zeitpunkt, zu dem die Messung nicht beeinflußt wird, herangezogen werden.

Die Erfindung erlaubt es, die Empfindlichkeit von Elektrometerverstärkern im eingebauten Zustand (z. B. Standby-Betrieb) zu testen, unter bestimmten Voraussetzungen auch deren Kalibrierung. Bei den hochempfindlichen Massenspektrometern für Helium-Lecksuchgeräte ist diese Möglichkeit der Überprüfung des Meßsignalpfades von Bedeutung.

Die beschriebene Überprüfung kann per Autocheck erfolgen, wenn entsprechende Steuermittel vorgesehen sind. Insbesondere die beschriebene Prüfmethode, bei der die ohnehin einzuschaltenden Betriebsspannungen rampenförmig hochgefahren werden und in den Teilchenfänger einen definierten Verschiebestrom einleiten, ist für den Autocheck geeignet.

## Patentansprüche

1. Verfahren zur Überprüfung des Meßsignalpfades eines Massenspektrometers mit einem Ionenfänger (25), einem dem Ionenfänger vorgelagerten Trenn- oder Ablenksystem (23, 24) und einem

dem Ionenfänger nachgeordneten Verstärker zur Bildung eines Spannungs- oder Stromsignals, indem ein Verschiebestrom in den Ionenfänger (25) eingeleitet wird, der mit Hilfe einer Spannungsänderung an einer Elektrode (23) des Trenn- oder Ablenksystems durch Influenz erzeugt wird.

2. Verfahren nach Anspruch 1, dadurch gekennzeichnet, daß an der Influenzelektrode (23) eine sägezahnförmige Spannung zur Erzeugung des Verschiebestromes angelegt wird.

3. Verfahren nach Anspruch 2, dadurch gekennzeichnet, daß als Maß für die Kontrolle der Funktion oder für die Messung der Empfindlichkeit die Differenz der positiven und der negativen Scheitelwerte einer rechteckförmigen Ausgangsspannung ($U_A$) der signalverarbeitenden Baugruppe verwendet wird, welche durch ein dreieckförmiges Spannungssignal ($U_G$) an der Influenzelektrode (23) hervorgerufen wird.

4. Verfahren nach Anspruch 1, dadurch gekennzeichnet, daß die Betriebsspannung, die die in dem Trenn- oder Ablenksystem vorhandene, während der Überprüfung des Meßsignalpfades als Influenzelektrode dienende Elektrode (23) benötigt, rampenförmig hoch- oder heruntergefahren wird und den gewünschten Verschiebestrom erzeugt.

5. Massenspektrometer zur Durchführung der Verfahren nach einem der Ansprüche 1 bis 4, dadurch gekennzeichnet, daß eine Elektrode (23) des dem Ionenfänger (25) vorgelagerten Trenn- oder Ablenksystems als Influenzelektrode dient und wahlweise an einen Spannungsgenerator (9) anschließbar ist.

## Claims

1. Method of checking the measuring signal path of a mass spectrometer having an ion trap (25), a separating or deflecting system (23, 24) mounted upstream of the ion trap and an amplifier located downstream of the ion trap for forming a voltage or current signal by introducing into the ion trap (25) a displacement current which is generated through electrostatic induction with the aid of a voltage change at an electrode (23) of the separating or deflecting system.

2. Method according to claim 1, characterised in that a saw-tooth shaped voltage for generating the displacement current is applied to the influence electrode (23).

3. Method according to claim 2, characterised in that, as a measure for testing correct functioning or for measuring sensitivity, the difference between the positive and negative peak values of a square-wave output voltage ($U_A$) of the signal processing subassembly is used which is created by means of a delta voltage signal ($U_G$) at the influence electrode (23).

4. Method according to claim, characterised in that the operating voltage required by the electrode (23), which is in the separating or deflecting system and serves as an influence electrode when checking the measuring signal path, is ramped up or down and generates the required displacement current.

5. Mass spectrometer for effecting the method according to one of claims 1 to 4, characterised in that an electrode (23) of the separating or deflecting system upstream of the ion trap (25) serves as an influence electrode and is optionally connectible to a voltage generator (9).

## Revendications

1. Procédé de vérification du chemin de signal de mesure d'un spectromètre de masse comportant un capteur d'ions (25), un système de séparation ou de déviation (23, 24) monté en amont du capteur d'ions et un amplificateur, monté en aval du capteur d'ions, pour former un signal de tension ou d'intensité, procédé consistant en ce que l'on provoque dans le capteur d'ions (25) un courant de déplacement qui est produit par induction à l'aide d'une modification de tension sur une électrode (23) du système de séparation ou de déviation.

2. Procédé selon la revendication 1, caractérisé en ce que, pour produire le courant de déplacement, on porte l'électrode d'induction (23) à une tension en forme de dents de scie.

3. Procédé selon la revendication 2, caractérisé en ce que comme valeur pour le contrôle du fonctionnement pour la mesure de la sensibilité, on emploie la différence des valeurs maximales positive et négative d'une tension de sortie rectangulaire ($U_A$) de l'ensemble de traitement du signal, tension provoquée par un signal de tension triangulaire ($U_G$) sur l'électrode d'induction (23).

4. Procédé selon la revendication 1, caractérisé en ce que l'on prend sous forme de rampe, par valeur croissante ou valeur décroissante, la tension d'exploitation nécessaire pour l'électrode (23) qui sert d'électrode d'induction, présente dans le système de séparation de déviation, pendant la vérification du chemin du signal de mesure; et en ce que c'est cette tension qui produit le courant de déplacement désiré.

5. Spectromètre de masse pour l'exécution du procédé selon l'une des revendications 1 à 4, caractérisé en ce que c'est une électrode (23) du système de séparation ou de déviation monté en amont du capteur d'ions (25) qui sert d'électrode d'induction et que l'on peut la raccorder au choix à un générateur de tension (9).

FIG.1

FIG. 2

FIG. 3

FIG. 4